(19) Europäisches Patentamt
European Patent Office
Office européen des brevets

(11) **EP 4 357 850 A1**

(12) **EUROPEAN PATENT APPLICATION**
published in accordance with Art. 153(4) EPC

(43) Date of publication:
**24.04.2024 Bulletin 2024/17**

(51) International Patent Classification (IPC):
*G03F 1/24 (2012.01)*

(21) Application number: **22824824.1**

(52) Cooperative Patent Classification (CPC):
**G03F 1/24**

(22) Date of filing: **02.06.2022**

(86) International application number:
**PCT/JP2022/022523**

(87) International publication number:
**WO 2022/264832 (22.12.2022 Gazette 2022/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.06.2021 JP 2021100675**

(71) Applicant: **Toppan Photomask Co., Ltd.
Tokyo 108-0023 (JP)**

(72) Inventors:
• **MIYAWAKI, Daisuke
Tokyo 110-0016 (JP)**
• **GODA, Ayumi
Tokyo 110-0016 (JP)**
• **NAKANO, Hideaki
Tokyo 110-0016 (JP)**
• **ICHIKAWA, Kenjiro
Tokyo 110-0016 (JP)**
• **YAMAGATA, Yuto
Tokyo 110-0016 (JP)**

(74) Representative: **Hoffmann Eitle
Patent- und Rechtsanwälte PartmbB
Arabellastraße 30
81925 München (DE)**

(54) **REFLECTIVE PHOTOMASK AND METHOD FOR MANUFACTURING REFLECTIVE PHOTOMASK**

(57)   There are provided a reflective photomask capable of reducing the shadowing effect and a method for manufacturing the reflective photomask. A reflective photomask (100) according to one aspect of the present disclosure includes: a substrate (11)); a reflective layer (12) having a multi-layer film structure formed on the substrate (11) and configured to reflect an EUV light; a protective layer (13) formed on the reflective layer (12) and configured to protect the reflective layer (12); and an absorption pattern layer (14a) formed on the protective layer (13) and formed with a pattern and configured to absorb the EUV light; in which the absorption pattern layer (14a) contains a material having an extinction coefficient k to the EUV light larger than 0.041, and a side wall angle θ formed by the side wall of the absorption pattern layer (14a) and the substrate (11) is less than 90°.

FIG. 1

**Description**

Technical Field

The present disclosure relates to a reflective photomask and a method for manufacturing a reflective photomask.

Background Art

In a manufacturing process of semiconductor devices, a demand for miniaturization by a photolithography technology has increased with the miniaturization of the semiconductor devices. The minimum development dimension of a transfer pattern in the photolithography largely depends on the wavelength of an exposure light source, and the minimum resolution dimension can be made smaller as the wavelength is shorter. Therefore, as the exposure light source in a manufacturing process of advanced semiconductor devices, an EUV (Extreme Ultraviolet) having a wavelength of 13.5 nm has been replaced with a conventional ArF excimer laser light having a wavelength of 193 nm.

Most materials have high light absorptivity to the EUV, and therefore a conventional dioptric system utilizing light transmission cannot be used. Thus, an optical member of an exposure machine is not a lens but a mirror. A photomask is also a reflective EUV photomask in place of a conventional transmission-type photomask. An incident light and a reflected light on the EUV photomask cannot be coaxially designed. Thus, in the EUV lithography, a technique is commonly employed which includes making the EUV light incident by tilting the optical axis by 6° from the vertical direction of the EUV photomask and emitting a reflected light reflected at an angle of -6° to a semiconductor substrate. However, the optical axis is tilted, causing a problem referred to as a so-called shadowing effect in which the EUV light incident on the EUV photomask creates a shadow of a mask pattern (absorption layer pattern) of the EUV photomask, deteriorating the transfer performance. Thus, it is an object to reduce the shadowing effect and improve the transfer performance.

To achieve the object, a reflective photomask has been proposed which reduces the shadowing effect by using a material having a high extinction coefficient k for an absorption layer to suppress the EUV reflectance, enabling the formation of the absorption layer pattern having a smaller film thickness than before (see, PTL 1, for example).

However, PTL 1 focuses only on a performance improvement due to the optical constants of materials and the film thickness, and does not consider the influence of the pattern shape on transferability.

Citation List

Patent Literature

PTL 1: WO 2018/159785

Summary of Invention

Technical Problem

It is an object of the present disclosure to provide a reflective photomask capable of reducing the shadowing effect and a method for manufacturing the reflective photomask.

Solution to Problem

To achieve the above-described object, a reflective photomask according to one aspect of the present disclosure includes: a substrate; a reflective layer having a multi-layer film structure formed on the substrate and configured to reflect an EUV light; a protective layer formed on the reflective layer and configured to protect the reflective layer; and an absorption pattern layer formed on the protective layer and formed with a pattern and configured to absorb the EUV light; in which the absorption pattern layer contains a material having an extinction coefficient k to the EUV light larger than 0.041, and a side wall angle $\theta$ formed by the side wall of the absorption pattern layer and the substrate is less than 90°.

Advantageous Effects of Invention

The reflective photomask according to one aspect of the present disclosure enables the reduction in the shadowing effect.

Brief Description of Drawings

FIG. 1 is a cross-sectional view schematically illustrating one configuration example of a reflective photomask according to this embodiment;

FIG. 2 is a graph showing the optical constant of each metal at the wavelength of an EUV light;

FIGS. 3A and 3B are cross-sectional views schematically illustrating one configuration example of the reflective photomask according to this embodiment

FIG. 4 is a schematic cross-sectional view illustrating a manufacturing process of the reflective photomask according to this embodiment;

FIG. 5 is a schematic cross-sectional view illustrating a manufacturing process of the reflective photomask according to this embodiment;

FIG. 6 is a schematic cross-sectional view illustrating a manufacturing process of the reflective photomask according to this embodiment;

FIG. 7 is a schematic cross-sectional view illustrating a manufacturing process of the reflective photomask according to this embodiment;

FIG. 8 is a schematic plan view illustrating a design pattern of a reflective photomask according to Examples of the present invention;

FIG. 9 is a graph showing NILS of the reflective photomask according to the embodiment of the present invention

FIGS. 10A to 10C are cross-sectional views schematically illustrating the configuration of a reflective photomask according to a modification of this embodiment; and

FIG. 11 is a graph showing the reflectance of a reflective photomask according to Examples of the present invention.

Description of Embodiments

One embodiment of the present disclosure will now be described with reference to the drawings.

Herein, the configurations illustrated in the drawings are schematic, and the relationship between the thickness and the plane dimension, the thickness ratio of each layer, and the like are different from the actual relationship, ratio, and the like. The embodiment described below exemplifies configurations for embodying the technical idea of the present disclosure. In the technical idea of the present disclosure, materials, shapes, structures, and the like of constituent components are not limited to the materials, shapes, structures, and the like described below. The technical idea of the present disclosure can be variously altered within the technical range defined by Claims.

(Configuration of reflective photomask)

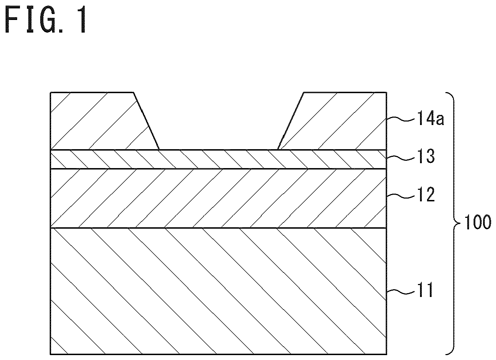

FIG. 1 is a schematic cross-sectional view illustrating the structure of a reflective photomask 100 according to an embodiment of the present invention. As illustrated in FIG. 1, the reflective photomask 100 according to the embodiment of the present invention includes a substrate 11, a reflective layer 12 formed on the substrate 11, a protective layer 13 formed on the reflective layer 12, and an absorption pattern layer 14a formed on the protective layer 13. Hereinafter, each layer is described in detail.

(Substrate)

For the substrate 11 according to the embodiment of the present invention, a flat Si substrate, synthetic quartz substrate, or the like is usable, for example. Further, a low thermal expansion glass to which titanium is added is usable for the substrate 11. However, the present invention is not limited to the above insofar as the material has a small thermal expansion coefficient.

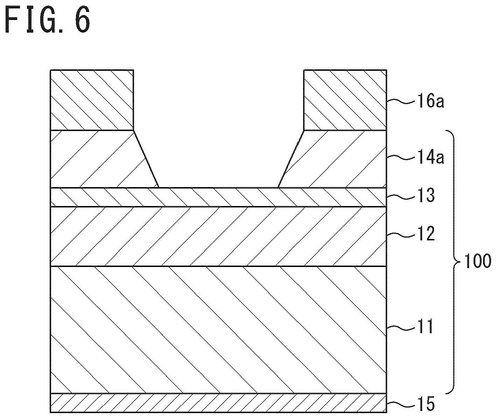

As illustrated in FIG. 6 described later, a back surface conductive film 15 can be formed on the surface on which the reflective layer 12 is not formed of the substrate 11. The back surface conductive film 15 is a film for fixing the reflective photomask 100 utilizing the principle of an electrostatic chuck when the reflective photomask 100 is installed in an exposure machine.

(Reflective layer)

The reflective layer 12 according to the embodiment of the present invention may be one reflecting an EUV light (extreme ultraviolet light) which is an exposure light or may be a multi-layer reflective film containing a combination of materials having greatly different refractive indices to the EUV light (i.e., an EUV light reflective film having a multi-layer film structure).

The reflective layer 12 including the multi-layer reflective film can be formed by repeatedly depositing a layer containing a combination of Mo (molybdenum) and Si (silicon) or Mo (molybdenum) and Be (beryllium) by about 40 cycles.

(Protective layer)

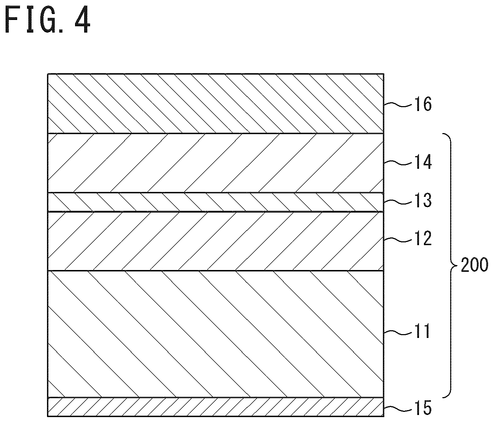

The protective layer 13 according to the embodiment of the present invention is a layer functioning as an etching stopper to prevent damage to the reflective layer 12 when the absorption pattern layer 14a is formed by etching. The protective layer 13 may not be provided depending on materials of the reflective layer 12 and etching conditions. The protective layer 13 is formed of a material resistant to dry etching performed in the pattern formation of an absorption layer 14 illustrated in FIG. 4 described later.

(Absorption layer and Absorption pattern layer)

As illustrated in FIG. 4, the absorption layer 14 is a layer formed on the protective layer 13 and is a layer absorbing an EUV light, which is an exposure light, in the reflective photomask 100. Further, the absorption layer 14 is a layer forming the absorption pattern layer (transfer pattern) 14a which is a fine pattern for transfer. More specifically, the absorption pattern (absorption pattern layer 14a) of the reflective photomask 100 illustrated in FIG. 1 is formed by removing a part of the absorption layer 14 of a reflective photomask blank 200, i.e., patterning the absorption layer 14.

In the EUV lithography, the EUV light is obliquely incident and reflected on the reflective layer 12, but the transfer performance onto a wafer (semiconductor substrate) sometimes deteriorates due to a shadowing effect in which the absorption pattern layer 14a interferes with an optical path.

It is known that this deterioration of the transfer performance can be reduced by reducing the thickness of the absorption pattern layer 14a absorbing the EUV light, but the deterioration of the transfer performance is further reduced by reducing the side wall angle of the absorption pattern layer 14a.

Hereinafter, materials for reducing the thickness of the absorption pattern layer 14a are described.

To reduce the thickness of the absorption pattern layer 14a, a material having higher absorptivity to the EUV light than that of a conventional material, i.e., a material having a high extinction coefficient k to a wavelength of 13.5 nm, is preferably applied to the absorption pattern layer 14a.

The extinction coefficient k of tantalum (Ta), which is a main material of the conventional absorption pattern layer 14a, is 0.041. When the main material of the absorption pattern layer 14a is a compound material having the extinction coefficient k larger than that of tantalum (Ta), the thickness of the absorption pattern layer 14a can be further reduced as compared with conventional compound materials, and the shadowing effect can be reduced.

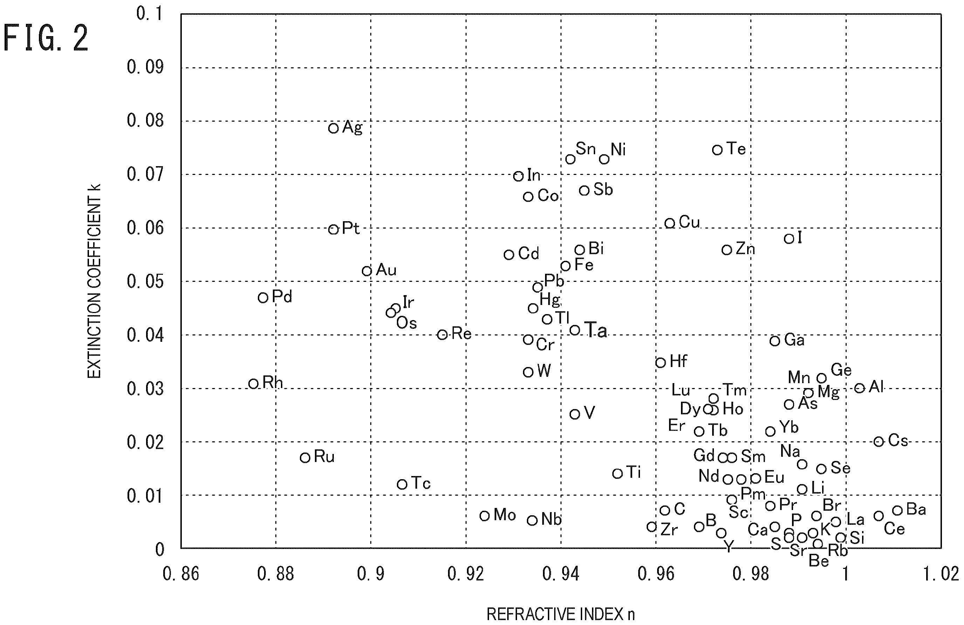

FIG. 2 is a graph showing the optical constant to the wavelength of 13.5 nm of the EUV light of each metal material. The horizontal axis of FIG. 2 represents the refractive index n and the vertical axis represents the extinction coefficient k. FIG. 2 shows that a "first material group" according to this embodiment has the extinction coefficient k larger than that of tantalum (Ta) which has been conventionally used, and therefore the shadowing effect can be reduced by using the first material group. The first material group contains tin (Sn), indium (In), tellurium (Te), and cobalt (Co), and oxides, nitrides, and oxynitrides thereof.

Herein, an optical density (OD) value which is an index showing the light intensity contrast between the reflective layer 12 and the absorption layer 14 (absorption pattern layer 14a). When the intensity of a reflected light from the reflective layer 12 is set as Rm and the intensity of a reflected light from the absorption layer 14 (absorption pattern layer 14a) is set as Ra, the optical density (OD) value is defined by Expression (1) below.

$$OD = -\log(Ra/Rm) \cdots \text{Equation (1)}$$

When the OD value is larger, the contrast is better and higher transferability is obtained. In the reflective photomask 100, the pattern transfer requires the OD value of 1 or more and more preferably OD > 1 but the OD value is more preferably 1.5 or more to obtain transfer performance higher than that of a conventional film containing tantalum (Ta) as the main material. Herein, the "main material" refers to a material (ingredient) contained in a proportion of 50 at% or more based on the number of atoms of the entire absorption layer 14 (absorption pattern layer 14a).

The film thickness of the absorption layer 14 (absorption pattern layer 14a) is preferably 50 nm or less. When the film thickness of the absorption layer 14 (absorption pattern layer 14a) is 50 nm or less, the shadowing effect can be sufficiently reduced and the transfer performance can be improved as compared with a conventional Ta-based absorption film.

Further, to obtain OD > 1, the film thickness of the absorption layer 14 (absorption pattern layer 14a) is preferably 17 nm or more.

Materials constituting the first material group have the extinction coefficient k to the EUV light higher than that of tantalum (Ta), which is the conventional material, and can be applied to the absorption layer 14. The application of the materials constituting the first material group to the absorption layer 14 can reduce the thickness of the absorption layer 14 and reduce the shadowing effect, and thus the improvement of the transferability can be expected. To further reduce the shadowing effect as compared with a conventional film containing tantalum (Ta) as the main material, the absorption layer 14 (absorption pattern layer 14a) desirably contains 50 at% or more in total of at least one or more elements selected from the first material group and oxides, nitrides, and oxynitrides thereof.

Materials containing at least one of tin (Sn), indium (In), tellurium (Te), and cobalt (Co) constituting the first material group enable dry etching processing with a fluorine-based gas or a chlorine-based gas which is a corrosive gas. In the first material group, tin (Sn) oxide or indium (In) oxide, tin (Sn) nitride or indium (In) nitride, tin (Sn) oxynitride or indium (In) oxynitride has a high melting point and is preferable. Among these materials, tin (Sn) oxide is the most preferable because of its ease of handling.

When the absorption layer 14 (absorption pattern layer 14a) contains at least one or more layers, at least one layer of the absorption layer 14 (absorption pattern layer 14a) may contain 50 at% or more in total of one or more elements selected from the above-described first material group and oxides, nitrides, and oxynitrides thereof.

When the absorption layer 14 (absorption pattern layer 14a) contains two or more layers, any layer may contain 50 at% or more in total of one or more elements selected from the above-described first material group and oxides, nitrides, and oxynitrides thereof. For example, the lowest layer (layer closest to the protective layer 13) of the absorption layer 14 (absorption pattern layer 14a) may contain 50 at% or more in total of one or more elements selected from the above-described first material group and oxides, nitrides, and oxynitrides thereof.

When the absorption layer 14 (absorption pattern layer 14a) contains three or more layers, the lowest layer of the absorption layer 14 (absorption pattern layer 14a) may contain 50 at% or more in total of one or more elements selected from the above-described first material group and oxides, nitrides, and oxynitrides thereof, and the content of the one or more elements selected from the first material group and the like may be reduced in a stepwise manner from the lowest layer to the uppermost layer (layer farthest from protective layer 13) .

(Side wall angle)

Hereinafter, the side wall angle of the absorption pattern layer 14a is described.

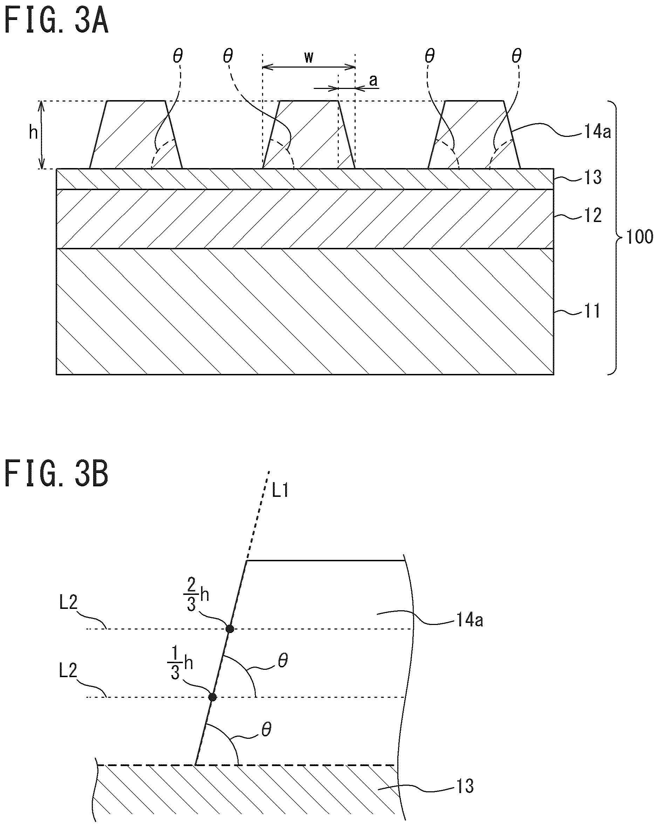

FIGS. 3A and 3B are schematic cross-sectional views illustrating the structure of the reflective photomask 100 according to this embodiment of the present invention. More specifically, FIG. 3A is a schematic cross-sectional view illustrating the entire structure of the reflective photomask 100 according to the embodiment of the present invention and FIG. 3B is a schematic cross-sectional view illustrating a part of the structure of the reflective photomask 100 according to the embodiment of the present invention in an enlarged manner. As illustrated in FIGS. 3A and 3B, the shadowing effect can be reduced by reducing the side wall angle θ formed by the side wall of the absorption pattern layer 14a and the protective layer 13 to be smaller than 90°.

Hereinafter, the definition of the side wall angle θ is described. As illustrated in FIGS. 3A, 3B, when the film thickness of the absorption pattern layer 14a is set as h, a straight line connecting the point of a side wall height h/3 portion in the cross-sectional view and the point of a side wall height 2h/3 portion is virtually drawn. The angle formed by the straight line (virtual straight line L1) and a straight line parallel to the substrate (virtual straight line L2) is the side wall angle θ.

According to the definition described above, also when a lower part or an upper part of the absorption pattern layer 14a is rounded, so that the side walls of the absorption pattern layer 14a are not on the same plane, for example, the side wall angles θ can be defined.

In this embodiment, the side wall angles θ in the opposing side walls of the absorption pattern layer 14a may be the same angle as illustrated in FIG. 3A.

When the absorption pattern layer 14a has a two or more layer-structure, the angle of the side wall angle θ of at least one layer may be smaller than 90°.

The absorption pattern layer 14a may have a structure in which the side wall angles θ of all of the layers may be the same angle or a layer (upper layer film) having the side wall angle θ of 90° is provided on a layer having the side wall angle θ smaller than 90°, for example. In this case, when the upper layer film is a film having low transparent to the EUV light, the film thickness of the upper layer film is desirably 20 nm or less and more desirably 10 nm or less not to impair the shadowing effect reduction effect by the adjustment of the side wall angle θ. However, this does not apply when the upper layer film has high transparency.

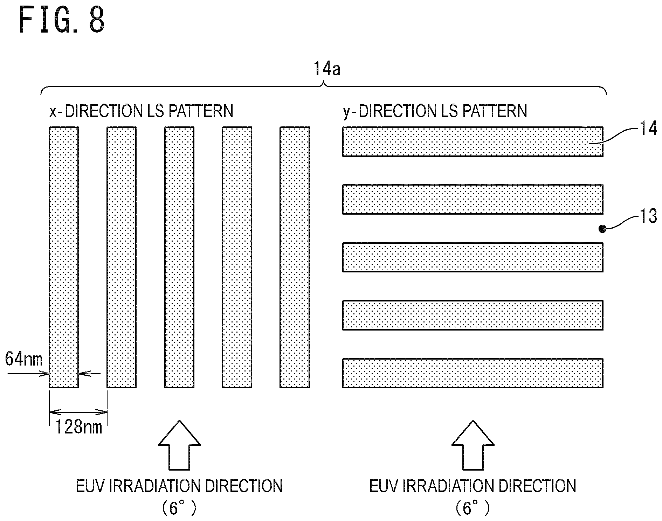

Herein, as illustrated in FIG. 8, an x-direction parallel to the plane of incidence of the EUV light and a y-direction perpendicular to the plane of incidence are defined.

The direction affected by the shadowing effect is the y-direction, and a decrease in the contrast or a decrease in the y-direction line width in an edge part of a transfer pattern occurs. By reducing the side wall angle θ, the shadowing effect decreases.

In the case of Side wall angle θ < 90°, the rightand-left symmetry of an energy latent image of a reflected light is improved, and therefore dimensional changes caused by distortion of the energy latent image are reduced. Therefore, an H-V bias value which is a difference between the x-direction dimension and the y-direction dimension illustrated in FIG. 8 decreases.

The film thickness h, the side wall angle θ, and the line width of a side wall portion described later in this embodiment are structurally limited. Hereinafter, the structural limitations are described.

As illustrated in FIG. 3A, when the film thickness of the absorption pattern layer 14a is h (nm), a line width a (nm) of the portion (side wall portion) forming the taper angle of the side wall (side wall angle θ) in the absorption pattern layer 14a is expressed by Equation (2) below.

$$a = h/\tan\theta \cdots \text{Equation (2)}$$

The line width a can be expressed by the film thickness h and the side wall angle θ of the absorption pattern layer 14a.

As illustrated in FIG. 3A, a line width w (nm) of the lower part of the absorption pattern layer 14a is structurally larger than twice the line width a of the side wall portion, and therefore the following inequality is established.

$$W > 2 \times a \cdots \text{Equation (3)}$$

Herein, the "line width w of the lower part of the absorption pattern layer 14a" means the width (line width) of a portion in contact with the protective layer 13 in the absorption pattern layer 14a.

By substituting Equation (2) above into Equation (3) above, Equation (4) below is derived.

$$\tan\theta > 2 \times h/w \cdots \text{Equation (4)}$$

Thus, the lower limit of the side wall angle θ of the absorption pattern layer 14a is defined by Equation (4) .

Herein, the x-direction illustrated in FIG. 8 is hardly affected by the shadowing effect. However, when the side wall angle θ is reduced, the thickness of an absorption portion decreases in a forward tapered section (i.e., the thickness of the absorption pattern layer 14a in the line width a of the side wall portion decreases), and the contrast decreases throughout the reflective photomask 100.

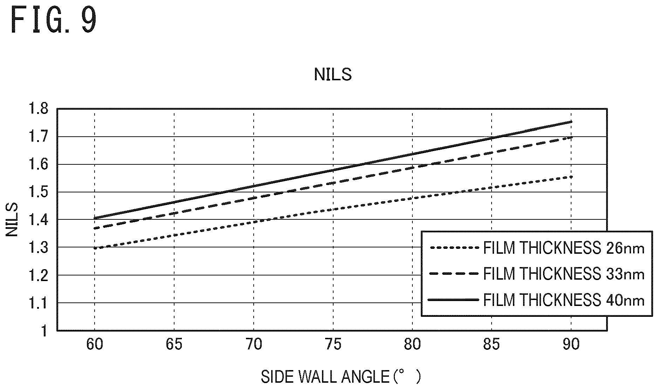

FIG. 9 is a graph of NILS. The NILS (Normalized Image Log-Slope) is determined by Equation (5) below and serves as an index of the resolution of the reflective photomask 100.

$$NILS = w \times d\ln(I)/dx \cdots \text{Equation (5)}$$

In Equation (5), "w" represents the line width (i.e., the width of a portion in contact with the protective layer 13 in the absorption pattern layer 14a) and "I" represents the intensity of the energy latent image.

As illustrated in FIG. 9, when the absorption pattern layer 14a having a film thickness of 40 nm and formed of tin oxide (SnO) has the side wall angle θ of 90°, the NILS value is 1.76. In contrast thereto, when the side wall angle θ is 65°, the NILS value is 1.46, and the value decreases by about 20% as compared with the case where the side wall angle θ is 90°.

Further, as illustrated in FIG. 9, also when the thickness of the absorption pattern layer 14a is 33 nm, the NILS value when the side wall angle θ is set to 65° decreases by about 20% as compared with the NILS value when the side wall angle θ is set to 90°.

Further, as illustrated in FIG. 9, also when the thickness of the absorption pattern layer 14a is 26 nm, the NILS value when the side wall angle θ is set to 65° decreases by about 20% as compared with the NILS value when the side wall angle θ is set to 90°.

From these facts, the side wall angle θ is preferably 65° or more to maintain a sufficient contrast.

As described above, the side wall angle θ is preferably 65° or more and less than 90° in this embodiment. However, the side wall angle θ is more preferably within the range of 80° or more and less than 90° and still more preferably within the range of 82° or more and 88° or less to obtain a sufficient contrast while reducing the shadowing effect.

(Method for manufacturing reflective photomask)

Next, a method for manufacturing a reflective photomask is described using FIGS. 4 to 8.

The reflective photomask blank 200 according to the embodiment of the present invention used to produce the reflective photomask 100 according to the embodiment of the present invention includes the substrate 11, the reflective layer 12 formed on the substrate 11, the protective layer 13 formed on the reflective layer 12, and the absorption layer 14 formed on the protective layer 13 as illustrated in FIG. 4.

First, a positive chemically amplified resist (SEBP9012: manufactured by Shin-Etsu Chemical Co., Ltd.) was formed by spin coating to have a film thickness of 120 nm on the absorption layer 14 provided in the reflective photomask blank 200. Thereafter, the resist was baked at 110°C for 10 min to form a resist pattern 16.

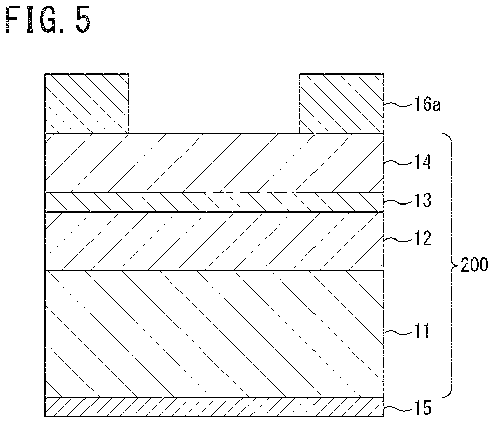

Next, a predetermined pattern was drawn on the resist film 16 formed of the positive chemically amplified resist by an electron beam lithography machine (JBX3030: manufactured by JEOL). Thereafter, baking treatment was performed at 110°C for 10 minutes, followed by spray development (SFG3000: manufactured by Sigma Meltec). Thus, a resist pattern 16a was formed as illustrated in FIG. 5.

Next, as illustrated in FIG. 6, the absorption layer 14 was patterned by dry etching mainly using a fluorine-based gas with the resist pattern 16a as an etching mask to form the absorption pattern layer 14a. At this time, the pressure or the bias (applied voltage) is adjusted to control the side wall angle $\theta$ of the absorption pattern layer 14a such that isotropic etching is performed. For the control of the side wall angle $\theta$ of the absorption pattern layer 14a, the side wall angle $\theta$ may also be adjusted by, for example, forming a hard mask on the absorption layer 14 or varying the resist species or the film thickness, besides the adjustment by the dry etching conditions.

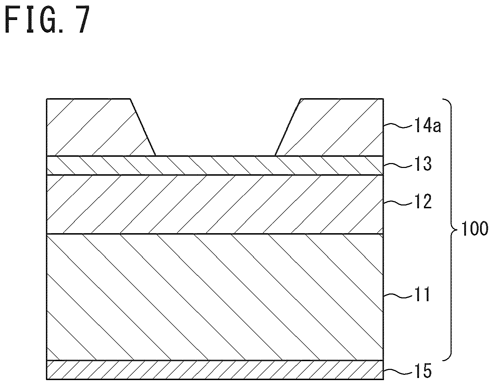

Next, the remaining resist pattern 16a was peeled off, thereby exposing the absorption pattern layer 14a as illustrated in FIG. 7.

As described above, the reflective photomask 100 according to this embodiment is manufactured. The absorption pattern layer 14a formed in the absorption layer 14 was set to an LS (line and space) pattern with a line width of 64 nm. The LS pattern with a line width of 64 nm is designed in each of the x-direction and the y-direction as illustrated in FIG. 8 such that the influence of the shadowing effect by the EUV irradiation is easily viewed.

(Modification of reflective photomask)

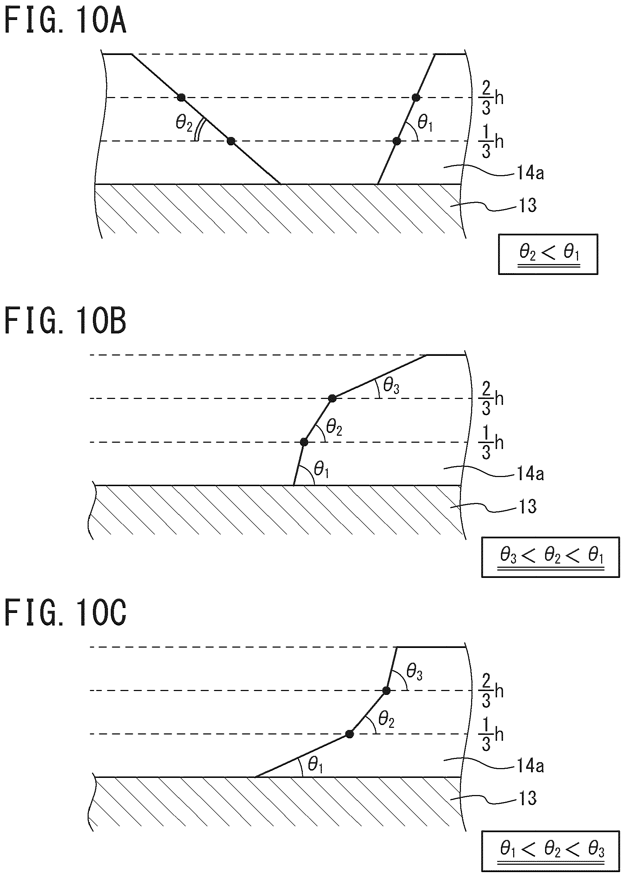

This embodiment describes the case where the side wall angles $\theta$ in the opposing side walls of the absorption pattern layer 14a are set to the same angle as illustrated in FIG. 3A, but the present invention is not limited to this case. For example, as illustrated in FIG. 10A, a side wall angle $\theta 1$ of one of the opposing side walls of the absorption pattern layer 14a may be set to be larger than a side wall angle $\theta 2$ of the other side wall. More specifically, the side wall angles $\theta$ in the opposing side walls of the absorption pattern layer 14a may be set to angles different from each other. In this case, it is preferable to make the side wall angle $\theta$ in the side wall of the absorption pattern layer 14a on the reflected light side smaller than the side wall angle $\theta$ in the side wall of the absorption pattern layer 14a on the incident light side because the shadowing effect can be further reduced.

This embodiment describes the case where the side walls of the absorption pattern layer 14a are constituted by the same plane, i.e., the side wall angles $\theta$ in the side walls of the absorption pattern layer 14a are always fixed, as illustrated in FIG. 3A, but the present invention is not limited to this case. For example, the side walls of the absorption pattern layer 14a may be formed such that the side wall angles $\theta$ become smaller in a stepwise manner from the protective layer 13 side toward the outermost surface side of the absorption pattern layer 14a as illustrated in FIG. 10B. More specifically, the side wall angles $\theta$ in the side walls of the absorption pattern layer 14a may have the relationship of $\theta 1 > \theta 2 > \theta 3$ as illustrated in FIG. 10B.

As illustrated in FIG. 10C, the side walls of the absorption pattern layer 14a may be formed such that the side wall angles $\theta$ become larger in a stepwise manner from the protective layer 13 side toward the outermost surface side of the absorption pattern layer 14a. More specifically, the side wall angles $\theta$ in the side walls of the absorption pattern layer 14a may have the relationship of $\theta 1 < \theta 2 < \theta 3$ as illustrated in FIG. 10C.

[EXAMPLES]

Hereinafter, the present disclosure is described in more detail with respect to Examples but the present disclosure is not limited by Examples at all.

<Example 1>

A synthetic quartz substrate having low thermal expansion properties was used as a substrate. On the substrate, a multi-layer reflective film was formed by depositing 40 multi-layer films each containing a pair of silicon (Si) and molybdenum (Mo). The film thickness of the multi-layer reflective film was set to 280 nm.

Next, a capping layer (protective layer) was formed to have a film thickness of 3.5 nm using ruthenium (Ru) on the multi-layer reflective film. Thus, a reflective part having the multi-layer reflective film and the capping layer was formed on the substrate.

On the capping layer, an absorption layer containing silver (Ag) and silicon (Si) was formed to have a film thickness of 52 nm. The atomic number ratio of silver (Ag) and silicon (Si) was 35:65 as measured by XPS (X-ray Photoelectron Spectroscopy). The crystallinity of the absorption layer measured by an XRD (X-ray diffractometer) showed that the absorption layer was amorphous although crystallinity was slightly observed.

Next, on the side on which the multi-layer reflective film was not formed of the substrate, a back surface conductive film was formed to have a film thickness of 100 nm using chromium nitride (CrN).

For the formation of each film on the substrate, a multi-source sputtering apparatus was used. The film thickness of each film was controlled by a sputtering time.

Next, a positive chemically amplified resist (SEBP9012: manufactured by Shin-Etsu Chemical Co., Ltd.) was formed by spin coating to have a film thickness of 120 nm on the absorption layer, and then baked at 110°C for 10 min to form a resist film.

Next, a predetermined pattern was drawn on the positive chemically amplified resist by an electron beam lithography machine (JBX3030: manufactured by JEOL).

Thereafter, prebaking treatment was performed at 110°C for 10 minutes, followed by development processing using a spray development machine (SFG3000: manufactured by Sigma Meltec). Thus, a resist pattern was formed.

Next, the absorption layer was patterned by dry etching mainly using a chlorine-based gas with the resist pattern as an etching mask to form an absorption pattern layer. At this time, the gas pressure or the bias (applied voltage) was adjusted such that the side wall angle was 80°.

Next, the remaining resist pattern was peeled off.

Thus, a reflective photomask of Example 1 was produced.

<Example 2>

The material of the absorption layer was changed to a mixed material (SnSiO) in which tin oxide (SnO) and silicon (Si) are homogeneous in an atomic number ratio of 50:50. A reflective photomask of Example 2 was produced in the same manner as in Example 1, except for the above.

<Example 3>

The film thickness of the absorption layer was changed to 41 nm. A reflective photomask of Example 3 was produced in the same manner as in Example 2, except for the above.

<Example 4>

The material of the absorption layer was changed to only tin oxide (SnO). The film thickness of the absorption layer was changed to 33 nm. A reflective photomask of Example 4 was produced in the same manner as in Example 1, except for the above.

<Example 5>

The side wall angle of the absorption pattern layer was changed to 70°. A reflective photomask of Example 5 was produced in the same manner as in Example 4, except for the above.

<Example 6>

The side wall angle of the absorption pattern layer was changed to 60°. A reflective photomask of Example 6 was produced in the same manner as in Example 1, except for the above.

<Example 7>

The film thickness of the absorption layer was changed to 46 nm. A reflective photomask of Example 7 was produced in the same manner as in Example 6, except for the above.

<Comparative Example 1>

In Comparative Example 1, a conventional photomask including an existing film containing tantalum (Ta) as the main material was used. In Comparative Example 1, an absorption layer was formed to have a film thickness of 58 nm using tantalum nitride (TaN) and an outermost layer was formed to have a film thickness of 2 nm using tantalum oxide (TaO), producing a reflective photomask. The side wall angle of the absorption pattern layer is 90°. A reflective photomask of Comparative Example 1 was produced in the same manner as in Example 1, except for the above.

<Comparative Example 2>

The material of the absorption layer was changed to only tin oxide (SnO). The film thickness of the absorption layer was changed to 33 nm. The side wall angle of the absorption pattern layer is 90°. A reflective photomask of Comparative Example 2 was produced in the same manner as in Example 1, except for the above.

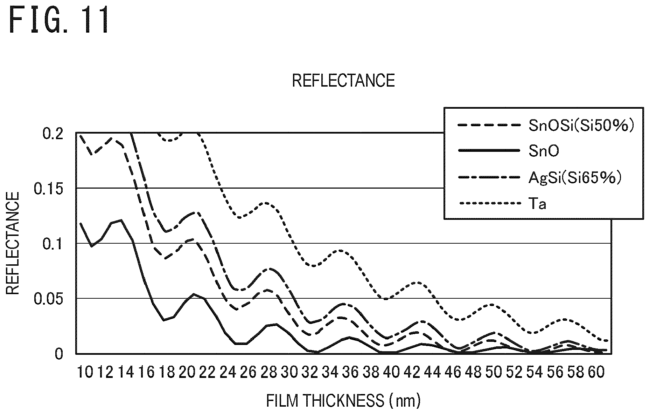

FIG. 11 illustrates the EUV light reflectance of the reflective photomask of each of Examples and each of Comparative Examples. The reflectance of the reflective photomask of Comparative Example 1 containing the conventional tantalum (Ta)-based absorption layer having a film thickness of 60 nm was 0.013 (OD = 1.68). In contrast thereto, the reflectance of the absorption layer having a film thickness of 52 nm and formed of a material containing 35% silver (Ag), i.e., the reflective photomask of Example 1, is 0.012 (OD = 1.74), the reflectance of the absorption layer having a film thickness of 41 nm and formed of a material containing 50% tin oxide (SnO), i.e., the reflective photomask of Example 3, is 0.013 (OD = 1.68), the reflectance of the absorption layer having a film thickness of 52 nm and formed of a material containing 35% silver (Ag), i.e., the reflective photomask of Example 6, is 0.012 (OD = 1.74), and the reflectance of the absorption layer having a film thickness of 46 nm and formed of a material containing 35% silver (Ag), i.e., the reflective photomask of Example 7, is 0.009 (OD = 1.86), which were equally excellent.

The reflectance of the absorption layer having a film thickness of 52 nm and formed of a material containing 50% tin oxide (SnO), i.e., the reflective photomask of Example 2, is 0.005 (OD = 2.11), and the reflectance of the absorption layer having a film thickness of 33 nm and formed of a material containing 100% tin oxide (SnO), i.e., the reflective photomask of each of Example 4, Example 5, and Comparative Example 2, is 0.001 (OD = 2.67), which were more excellent.

A case where the OD value was 2.0 or more was evaluated as "◎", a case where the OD value was 1.5 or more was evaluated as "o", a case where the OD value was 1.0 or more was evaluated as "Δ", and a case where the OD value was less than 1.0 was evaluated as "×".

With regard to the OD value, those having the evaluation equal to or higher than "Δ" have no problems in use, and therefore were accepted.

<Evaluation>

The reflective photomasks obtained in Examples 1 to 7, Comparative Examples 1 and 2 described above were evaluated for the transfer performance by the following method. The transfer performance was confirmed by a wafer exposure evaluation. The resolution was evaluated by the NILS (Normalized Image Log-Slope) value.

[Wafer exposure evaluation]

An absorption layer pattern of the reflective photomask produced in each of Examples, Comparative Example 2, and Reference Example (Comparative Example 1) was transferred and exposed onto a semiconductor wafer coated with an EUV positive chemically amplified resist using an EUV exposure apparatus (NXE3300B: manufactured by ASML). At this time, the exposure amount was adjusted such that the x-direction LS pattern was transferred as designed. Thereafter, the observation and the line width measurement of the transferred resist pattern were carried out by an electron beam dimension measuring machine, and then the resolution and the H-V bias value were confirmed and evaluated based on the following four levels of "◎", "o", "Δ", "×".

<Evaluation criteria>

◎: Case where the H-V bias value is smaller than 3.2 nm.
o: Case where the H-V bias value is 3.2 nm or more and smaller than 3.7 nm.
Δ: Case where the H-V bias value is 3.7 nm or more and 5.0 nm or less.
×: Case where the H-V bias value exceeds 5.0 nm.

Table 1 shows the evaluation results above.

With regard to the HV-bias value, those having the evaluation equal to or higher than "o" have no problems in use, and therefore were accepted.

[Resolution evaluation]

The reflective photomasks produced in Examples, Comparative Example 2, and Reference Example (Comparative Example 1) were evaluated for the resolution of the absorption layer pattern using the NILS values. The resolution was evaluated based on the following three levels of "∘", "Δ", "×".

<Evaluation criteria>

∘: Case where the NILS value is 1.4 or more.
Δ: Case where the NILS value is 1.0 or more and less than 1.4.
×: Case where the NILS value is less than 1.0.

Table 1 shows the evaluation results above.

With regard to the NILS value, those having the evaluation equal to or higher than "Δ" have no problems in use, and therefore were accepted.

[Table 1]

| | | Film thickness (nm) | Side wall angle (°) | Evaluation items | | | Evaluation results | | |
|---|---|---|---|---|---|---|---|---|---|
| | Material | | | OD value | H-V bias value | NILS value | OD | H-V bias | Resolution |
| Ex. 1 | AgSi (Si 65%) | 52 | 80 | 1.74 | 3.6 | 1.68 | ○ | ○ | ○ |
| Ex. 2 | SnOSi (Si 50%) | 52 | 80 | 2.11 | 3.6 | 1.66 | ◎ | ○ | ○ |
| Ex. 3 | SnOSi (Si 50%) | 41 | 80 | 1.68 | 3.1 | 1.41 | ○ | ◎ | ○ |
| Ex. 4 | SnO | 33 | 80 | 2.67 | 3.0 | 1.59 | ◎ | ◎ | ○ |
| Ex. 5 | SnO | 33 | 70 | 2.67 | 2.6 | 1.49 | ◎ | ◎ | ○ |
| Ex. 6 | AgSi (Si 65%) | 52 | 60 | 1.74 | 2.3 | 1.24 | ○ | ◎ | △ |
| Ex. 7 | AgSi (Si 65%) | 46 | 60 | 1.86 | 2.2 | 1.23 | ○ | ◎ | △ |
| Comp. Ex. 1 | Existing Ta | 60 | 90 | 1.68 | 5.2 | 1.74 | ○ | × | ○ |
| Comp. Ex. 2 | SnO | 33 | 90 | 2.67 | 3.7 | 1.69 | ◎ | △ | ○ |

As shown in Table 1, the evaluation results of Examples 1 to 7, Comparative Examples 1 and 2 showed that, the H-V bias value when the side wall angle of the absorption pattern layer is $\theta < 90°$ as in Examples 1 to 7 is smaller than that when the side wall angle of the absorption pattern layer is $\theta = 90°$ as in Comparative Examples 1 and 2, and the shadowing effect can be reduced.

Hereinafter, the results of comparing the H-V bias values of Examples and Comparative Examples are specifically described.

The H-V bias value of Comparative Example 1 having the conventional tantalum (Ta)-based absorption layer having a film thickness of 60 nm was 5.2 nm, and the H-V bias value of Comparative Example 2 having a film thickness of 33 nm, formed of tin oxide (SnO), and having a side wall angle of 90° was 3.7 nm.

In contrast thereto, the H-V bias value of Example 1 having a film thickness of 52 nm, formed of a material containing silver (Ag) and silicon (Si) to have an atomic number ratio of 35:65, and having a side wall angle of 80° is 3.6 nm, the H-V bias value of Example 2 having a film thickness of 52 nm, formed of a material containing tin oxide (SnO) and silicon (Si) to have an atomic number ratio of 50:50, and having a side wall angle of 80° is 3.6 nm, the H-V bias value of Example 3 having a film thickness of 41 nm, formed of a material containing tin oxide (SnO) and silicon (Si) to have an atomic number ratio of 50:50, and having a side wall angle of 80° is 3.1 nm, the H-V bias value of Example 4 having a film thickness of 33 nm, formed of only tin oxide (SnO), and having a side wall angle of 80° is 3.0 nm, the H-V bias value of Example 5 having a film thickness of 33 nm, formed of only tin oxide (SnO), and having a side wall angle of 70° is 2.6 nm, the H-V bias value of Example 6 having a film thickness of 52 nm, formed of a material containing silver (Ag) and silicon (Si) to have an atomic number ratio of 35:65, and having a side wall angle of 60° is 2.3 nm, and the H-V bias value of Example 7 having a film thickness of 46 nm, formed of a material containing silver (Ag) and silicon (Si) to have an atomic number ratio of 35:65, and having a side wall angle of 60° is 2.2 nm, which showed that the H-V bias values are smaller than the H-V bias value in the case of Side wall angle θ = 90° and the shadowing effect can be reduced.

The reflective photomask and the method for manufacturing the reflective photomask of the present disclosure are not limited to the embodiment and examples described above, and can be variously altered insofar as the features of the invention are not impaired.

Industrial Applicability

The reflective photomask blank and the reflective photomask according to the present invention can be suitably used for forming a fine pattern by EUV exposure in a manufacturing process of a semiconductor integrated circuit and the like.

Reference Signs List

| | |
|---|---|
| 11 | substrate |
| 12 | reflective layer |
| 13 | protective layer |
| 14 | absorption layer |
| 14a | absorption pattern (absorption pattern layer) |
| 15 | back surface conductive film |
| 16 | resist film |
| 16a | resist pattern |
| 100 | reflective photomask |
| 200 | reflective photomask blank |

**Claims**

1.  A reflective photomask comprising:

    a substrate;
    a reflective layer having a multi-layer film structure formed on the substrate and configured to reflect an EUV light;
    a protective layer formed on the reflective layer and configured to protect the reflective layer; and
    an absorption pattern layer formed on the protective layer and formed with a pattern and configured to absorb the EUV light; wherein
    the absorption pattern layer contains a material having an extinction coefficient k to the EUV light larger than 0.041, and
    a side wall angle θ formed by a side wall of the absorption pattern layer and the substrate is less than 90°.

2.  The reflective photomask according to claim 1, wherein

    the absorption pattern layer contains at least one or more layers,
    at least one layer of the absorption pattern layer contains 50 at% or more in total of one or more elements selected from a first material group and oxide, nitride, and oxynitride of the one or more elements selected from the first material group, and
the first material group consists of Sn, In, Te, and Co.

3. The reflective photomask according to claim 1 or 2, wherein

the absorption pattern layer has a film thickness less than 50 nm, and
an OD value (Optical Density) is 1.0 or more.

4. The reflective photomask according to any one of claims 1 to 3, wherein

a line width of a lower part of the absorption pattern layer is set as w (nm) and the film thickness of the absorption pattern layer is set as h (nm),
the side wall angle θ satisfies a relationship expressed by

$$\tan \theta > 2 \times h/w.$$

5. The reflective photomask according to any one of claims 1 to 4, wherein
the side wall angle θ satisfies

$$65° \leq \theta < 90°.$$

6. The reflective photomask according to any one of claims 1 to 5, wherein
the absorption pattern layer is formable by dry etching using a fluorine-based gas or a chlorine-based gas.

7. A method for manufacturing a reflective photomask comprising:

forming a substrate;
a reflective layer having a multi-layer film structure formed on the substrate and configured to reflect an EUV light;
a protective layer formed on the reflective layer and configured to protect the reflective layer; and
an absorption pattern layer formed on the protective layer and formed with a pattern and configured to absorb the EUV light; wherein
the absorption pattern layer is formed of a material having an extinction coefficient k of the EUV light larger than 0.041, and
a side wall angle θ formed by a side wall of the absorption pattern layer and the substrate is less than 90°.

FIG. 1

# FIG. 2

# FIG. 3A

# FIG. 3B

FIG. 4

# FIG. 5

# FIG. 6

FIG. 7

# FIG. 8

14a

x-DIRECTION LS PATTERN

y-DIRECTION LS PATTERN

14

13

64nm

128nm

EUV IRRADIATION DIRECTION
(6°)

EUV IRRADIATION DIRECTION
(6°)

# FIG. 9

NILS

# FIG. 10A

$\theta_2$

$\theta_1$

$\frac{2}{3}h$

$\frac{1}{3}h$

14a

13

$$\underline{\underline{\theta_2 < \theta_1}}$$

# FIG. 10B

$\theta_3$

$\theta_2$

$\theta_1$

$\frac{2}{3}h$

$\frac{1}{3}h$

14a

13

$$\underline{\underline{\theta_3 < \theta_2 < \theta_1}}$$

# FIG. 10C

$\theta_3$

$\theta_2$

$\theta_1$

$\frac{2}{3}h$

$\frac{1}{3}h$

14a

13

$$\underline{\underline{\theta_1 < \theta_2 < \theta_3}}$$

# FIG. 11

## INTERNATIONAL SEARCH REPORT

| International application No. |
|---|
| **PCT/JP2022/022523** |

**A. CLASSIFICATION OF SUBJECT MATTER**

*G03F 1/24*(2012.01)i
FI: G03F1/24

According to International Patent Classification (IPC) or to both national classification and IPC

**B. FIELDS SEARCHED**

Minimum documentation searched (classification system followed by classification symbols)

G03F1/24

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2013-532381 A (CARL ZEISS SMT GMBH) 15 August 2013 (2013-08-15) claims 1, 7-13, paragraphs [0069]-[0090], fig. 7 | 1-7 |
| Y | JP 2020-34666 A (HOYA CORP) 05 March 2020 (2020-03-05) paragraphs [0062]-[0067], [0109]-[0110], fig. 1 | 1-7 |
| Y | JP 2021-85998 A (TOPPAN PRINTING CO LTD) 03 June 2021 (2021-06-03) paragraphs [0006], [0017]-[0020], [0027]-[0028] | 3 |
| A | JP 2011-166039 A (DAINIPPON PRINTING CO LTD) 25 August 2011 (2011-08-25) entire text, all drawings | 1-7 |
| A | JP 2009-147200 A (TOPPAN PRINTING CO LTD) 02 July 2009 (2009-07-02) entire text, all drawings | 1-7 |
| A | JP 2006-148113 A (SAMSUNG ELECTRONICS CO LTD) 08 June 2006 (2006-06-08) entire text, all drawings | 1-7 |

☐ Further documents are listed in the continuation of Box C.  ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 July 2022** | **19 July 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | Telephone No. |

Form PCT/ISA/210 (second sheet) (January 2015)

# EP 4 357 850 A1

| INTERNATIONAL SEARCH REPORT | | | International application No. |
|---|---|---|---|
| Information on patent family members | | | **PCT/JP2022/022523** |

| Patent document cited in search report | | | Publication date (day/month/year) | Patent family member(s) | Publication date (day/month/year) |
|---|---|---|---|---|---|
| JP | 2013-532381 | A | 15 August 2013 | US 2013/0100428 A1 claims 1, 7-13, paragraphs [0078]-[0099], fig. 7 WO 2011/157643 A1 CN 102947759 A KR 10-2013-0087011 A | |
| JP | 2020-34666 | A | 05 March 2020 | US 2021/0311382 A1 paragraphs [0073]-[0079], [0122]-[0123], fig. 1 KR 10-2021-0043563 A | |
| JP | 2021-85998 | A | 03 June 2021 | TW 2021-129704 A paragraphs [0006], [0017]-[0020], [0027]-[0028] | |
| JP | 2011-166039 | A | 25 August 2011 | (Family: none) | |
| JP | 2009-147200 | A | 02 July 2009 | (Family: none) | |
| JP | 2006-148113 | A | 08 June 2006 | US 2006/0134531 A1 entire text, all drawings KR 10-2006-0055304 A CN 1811593 A | |

Form PCT/ISA/210 (patent family annex) (January 2015)